# EUROPEAN PATENT APPLICATION

(11) **EP 3 399 852 A1**
(43) Date of publication of application: **07.11.2018**
(21) Application number: 16881083.6
(22) Date of filing: 22.12.2016
(51) Int. Cl.: H05K 5/04

(54) **ALUMINUM ALLOY HOUSING AND PREPARATION METHOD THEREFOR**

(30) Priority: 30.12.2015 CN 201511022949
(71) Applicant: BYD Company Limited, Shenzhen, Guangdong 518118 (CN)
(72) Inventor: LIAO, Chongchong, Shenzhen Guangdong 518118 (CN); XIONG, Xiong, Shenzhen Guangdong 518118 (CN); SHI, Fengyun, Shenzhen Guangdong 518118 (CN); HU, Youcheng, Shenzhen Guangdong 518118 (CN)
(74) Representative: Gulde & Partner
(86) International application number: PCT/CN2016/111570
(87) International publication number: WO 2017/114294

(57) **Abstract**

Provided are an aluminum alloy housing and a preparation method for same. An external surface of the aluminum alloy housing has a convex portion and a concave portion, the convex portion has a convex oxide film, the concave portion has a concave oxide film, and surfaces of the convex oxide film and the concave oxide film have a glossiness of 90-150.

## Description

### Technical Field

The present invention relates to the field of electronic product technologies, and in particular, to an aluminum alloy housing and a preparation method for same.

### Related Art

With the development of electronic technologies, increasingly more electronic products appear in our life, for example, mobile phones, tablet computers, and e-readers. Most of these electronic products use plastic casings. However, as people have higher requirements on the quality of the electronic products, more and more electronic products use metal casings. On one hand, metal casings have better protection effects than plastic casings. On the other hand, the unique metal texture is also an important reason why the metal casings are becoming more popular.

Currently, surface treatment is performed on a metal casing of an electronic product mainly for the purpose of decorative and protective effects. In an existing method of performing surface treatment on a metal casing, anodic oxidation, micro-arc oxidation, and hard anodic oxidation on the surface of the metal casing can all achieve the foregoing two effects. However, in terms of the decorative effect, the metal casing after the treatment lacks diversity in appearance decoration and textures.

Therefore, a metal casing obtained by using the foregoing surface treatment technology lacks diversity in appearance decoration and textures. It is necessary to develop an aluminum alloy housing that has desirable appearance decoration and a solid texture, and a preparation method for same.

### SUMMARY

In order to resolve the problem that a mobile phone housing in the prior art lacks diversity in appearance decoration and textures, the present invention is directed to provide an aluminum alloy housing and a preparation method for same. The aluminum alloy housing has a bumpy solid texture and has a glossy convex side and concave side.

In order to achieve the foregoing objective, the present invention provides an aluminum alloy housing. According to embodiments of the present invention, an external surface of the aluminum alloy housing has a convex portion and a concave portion, the convex portion has a convex oxide film, the concave portion has a concave oxide film, and surfaces of the convex oxide film and the concave oxide film have a glossiness of 90-150.

Preferably, a height difference between the convex portion and the concave portion is 0.05-0.2 mm.

Preferably, the convex oxide film and the concave oxide film have different colors.

The present invention further provides a preparation method for an aluminum alloy housing, where the preparation method sequentially includes:
step a: performing anti-etching protection on a surface of an aluminum alloy housing substrate, so as to form a protective film on the surface of the aluminum alloy housing substrate;
step b: forming, by using an etching method, a pattern layer having a convex-concave pattern on the surface of the aluminum alloy housing substrate on which the protective film is formed;
step c: performing first anodic oxidation on the surface of the aluminum alloy housing substrate having the pattern layer;
step d: removing the protective film from the surface of the aluminum alloy housing substrate on which the first anodic oxidation has been performed, to perform deprotection;
step e: performing second anodic oxidation on the surface of the aluminum alloy housing substrate from which the protective film has been removed; and
step f: performing mechanical polishing on the surface of the aluminum alloy housing substrate on which the second anodic oxidation has been performed.

Preferably, in step a, the anti-etching protection includes: spraying an anti-etching photo-sensitive ink on the surface of the aluminum alloy housing substrate and curing; disposing a film in a region where a pattern needs to be formed, covering the film with a silicone membrane, and performing exposure; and washing away an unexposed part of the anti-etching photo-sensitive ink to perform development.

Preferably, a condition of the curing is: drying for 10-20 min at a temperature of 80-85°C.

Preferably, in step b, the etching method is etching for 1-10 min at a temperature of 40-45°C by using an acid etchant solution.

Preferably, the acid etchant solution contains 100-150 parts by weight of ferric chloride and 80-120 parts by weight of phosphoric acid with respect to 100 parts by weight of water.

Preferably, the first anodic oxidation and/or the second anodic oxidation includes performing pretreatment on the surface of the aluminum alloy housing substrate and then forming an anode film by means of anodic oxidation.

Preferably, the pretreatment includes: performing alkali etching for 3-20s at a temperature of 50-70°C by using 50-60 g/L of sodium hydroxide, neutralizing for 10-20s a temperature of 15-25°C by using 200-300 ml/L of nitric acid, and performing chemical polishing for 5-20s at a temperature of 90-95°C by using a chemical polishing solution containing 650-750 ml/L of phosphoric acid and 350-250 ml/L of sulfuric acid.

Preferably, the anodic oxidation includes oxidizing the surface of the aluminum alloy housing substrate for 15-50 min under an anode voltage of 13-17 V and at a temperature of 10-21°C by using 190-200 g/L of sulfuric acid.

By means of the foregoing technical solution, an ink is first sprayed on the surface of the aluminum alloy housing substrate for protection, and then the surface is etched to have a bumpy effect. Next, after first anodic oxidation and second anodic oxidation, the oxide film formed on the surface of the aluminum alloy housing substrate is polished, thereby producing an aluminum alloy housing having a bumpy solid texture and having a glossy convex side and concave side.

The additional aspects and advantages of the present invention will be provided in the following description, and some of the additional aspects and advantages will become clear in the following description or be understood through practice of the present invention.

**DETAILED DESCRIPTION**

Specific implementations of the present invention are described in detail below. It should be understood that the specific implementations described herein are merely used for illustrating the present invention rather than limiting the present invention.

An aluminum alloy housing is provided according to an embodiment of the present invention. An external surface of the aluminum alloy housing has a convex portion and a concave portion, the convex portion has a convex oxide film, the concave portion has a concave oxide film, and surfaces of the convex oxide film and the concave oxide film have a glossiness of 90-150. The inventor finds that, by forming a convex portion and a concave portion on the external surface of the aluminum alloy housing, the aluminum alloy housing can have a bumpy solid texture. In addition, by polishing the convex oxide film and the concave oxide film formed on the surfaces of the convex portion and the concave portion, the surfaces of the convex oxide film and the concave oxide film are glossy. In the present invention, the glossiness means how close the surface of the oxide film is to a mirror surface, and can be measured by using a method commonly known in the field, for example, measured by using a gloss meter.

In the present invention, a method for forming a convex portion and a concave portion on the external surface of the aluminum alloy housing, and a method for forming a convex oxide film on the convex portion and forming a concave oxide film on the concave portion will be described in the following preparation method for the aluminum alloy housing.

In the preparation method for the aluminum alloy housing according to an embodiment of the present invention, preferably, the convex oxide film and the concave oxide film are of different colors. By making the convex oxide film and the concave oxide film have different colors, the aluminum alloy housing has film layers of different colors.

A preparation method for an aluminum alloy housing according to an embodiment of the present invention sequentially includes:
step a: performing anti-etching protection on a surface of an aluminum alloy housing substrate, so as to form a protective film on the surface of the aluminum alloy housing substrate;
step b: forming, by using an etching method, a pattern layer having an uneven pattern on the surface of the aluminum alloy housing substrate on which the protective film is formed;
step c: performing first anodic oxidation on the surface of the aluminum alloy housing substrate having the pattern layer;
step d: removing the protective film from the surface of the aluminum alloy housing substrate on which the first anodic oxidation has been performed, to perform deprotection;
step e: performing second anodic oxidation on the surface of the aluminum alloy housing substrate from which the protective film has been removed; and
step f: performing mechanical polishing on the surface of the aluminum alloy housing substrate on which the second anodic oxidation has been performed.

The aluminum alloy housing substrate used in the present invention is not particularly limited. Various aluminum alloy housing bodies can be used, for example, a product of industrial standard 1000-7000 series, a die-casting aluminum alloy, and a pressure-casting aluminum alloy. The aluminum alloy housing substrate in the present invention is an aluminum alloy housing body of various shapes and structures that are commonly used by a person skilled in the art, and is not particularly limited in the present invention. The various shapes and structures of the aluminum alloy housing substrate can be accomplished by mechanical processing. The aluminum alloy housing can be used as a housing of a mobile phone, a tablet computer, an e-reader, or the like.

In the preparation method for an aluminum alloy housing according to the embodiment of the present invention, in order to obtain a glossy effect of the aluminum alloy housing, mechanical polishing is performed on the surface of the aluminum alloy housing substrate on which the second anodic oxidation has been performed. The anodic oxidation film layer on the surface of the aluminum alloy housing substrate is polished by using a mechanical polishing machine, to reduce the overall thickness of the anodic oxidation film layer by approximately 2 µm, so that the surface of the anodic oxidation film is glossy and can reflect light.

In the present invention, an ink is first sprayed on the surface of the aluminum alloy housing substrate for protection, and then the surface is etched to form a pattern layer having a bumpy effect. Next, after first anodic oxidation is performed, the ink protection on the pattern layer surface is removed. Second anodic oxidation is performed on part of the pattern layer, to produce an aluminum alloy housing having a bumpy solid texture and having a glossy convex side and concave side.

In the preparation method for an aluminum alloy housing according to the embodiment of the present invention, in step a, before the protective film is formed on the surface of the aluminum alloy housing substrate, blasting and drawing treatment can be performed on the surface of the aluminum alloy housing substrate in advance. In the present invention, the blasting can be performed by using a method commonly known in the field. For example, after the surface of the aluminum alloy housing substrate is sanded by using a sander, blasting treatment is performed on the surface of the aluminum alloy housing substrate by using a ceramic sand of 80-400 meshes under a pressure of 0.1-0.24 MPa, so that the surface of the aluminum alloy housing substrate feels sandy. The drawing treatment can be performed by using a method commonly known in the field. For example, the surface of the aluminum alloy housing substrate can be drawn by a drawing machine with No. 400 to No. 1200 drawing wheels to achieve the required brushed texture from coarse to fine.

In the preparation method for an aluminum alloy housing according to the embodiment of the present invention, in step a, anti-etching protection is performed on the surface of the aluminum alloy housing substrate to form a protective film, which can effectively protect the aluminum alloy housing substrate and prevent corrosion in the etching process, so that a convex-concave pattern structure with a clear hierarchy is formed in the aluminum alloy housing substrate. Preferably, a specific process can include, for example, spraying an anti-etching photo-sensitive ink on the surface of the aluminum alloy housing substrate and curing; disposing a film in a region where a pattern needs to be formed, covering the film with a silicone membrane, and performing exposure; and washing away an unexposed part of the anti-etching photo-sensitive ink to perform development. The anti-etching photo-sensitive ink used in the present invention can be a conventional ink in the field, as long as the anti-etching and photo-sensitive requirements can be met. For example, Vitayon 5680 series anti-etching UV ink (Shenzhen Vitayon Co., Ltd.) can be used.

In the preparation method for an aluminum alloy housing according to the embodiment of the present invention, preferably, the aluminum alloy housing substrate attached with the anti-etching photo-sensitive ink can be put into a drying oven for curing, and a condition of the curing may be drying for 10-20 min at a temperature of 80-85°C.

In the preparation method for an aluminum alloy housing according to the embodiment of the present invention, preferably, after the surface of the aluminum alloy housing substrate is cured, a film is disposed in a region where a pattern needs to be formed on the surface of the aluminum alloy housing substrate, a layer of silicone membrane is covered on the film, and then the film is pressed tightly on the surface of the aluminum alloy housing substrate by using a jig. Exposure is performed under UV irradiation with an intensity of 100 mJ/cm² for 25s.

In the preparation method for an aluminum alloy housing according to the embodiment of the present invention, preferably, the aluminum alloy housing substrate after the exposure is eluted at room temperature (25°C) by using a sodium carbonate solution with a concentration of 1% by weight, an injection pressure being 200 kPa. An unexposed part of the anti-etching photo-sensitive ink on the surface of the aluminum alloy housing substrate is washed away, to show a desired pattern.

In the preparation method for an aluminum alloy housing according to the embodiment of the present invention, preferably, in step b, the etching method can be etching for 1-10 min at a temperature of 40-45°C by using an acid etchant solution. For example, the aluminum alloy housing substrate is soaked in the acid etchant solution, and the etchant solution is stirred continuously to perform etching. A convex-concave depth difference of 0.05-0.2 mm can be formed on the surface of aluminum alloy housing substrate by means of etching, thereby presenting a clear bumpy solid texture.

In the preparation method for an aluminum alloy housing according to the embodiment of the present invention, preferably, the acid etchant solution can contain 100-150 parts by weight of ferric chloride and 80-120 parts by weight of phosphoric acid with respect to 100 parts by weight of water. In addition, after the pattern layer is formed on the surface of the aluminum alloy housing substrate through etching, blasting treatment can be performed on an exposed part of the substrate after the etching. The blasting treatment can be performed by using a method commonly known in the field. For example, after the surface of the aluminum alloy housing substrate is sanded by using a sander, blasting treatment can be performed on the surface of the aluminum alloy housing substrate by using a ceramic sand of 80-400 meshes under a pressure of 0.1-0.24 MPa, so that the surface of the aluminum alloy housing substrate feels sandy.

In the preparation method for an aluminum alloy housing according to the embodiment of the present invention, preferably, the first anodic oxidation and/or the second anodic oxidation may include performing pretreatment on the surface of the aluminum alloy housing substrate and then forming an anode film by means of anodic oxidation. There is no special requirement on the thickness of the formed anode film, and the thickness is usually 6-10 µm.

In the preparation method for an aluminum alloy housing according to the embodiment of the present invention, preferably, the pretreatment is performed to make the surface of the aluminum alloy housing substrate clean and ensure that a uniform anode film is formed on the surface of the aluminum alloy housing substrate by means of anodic oxidation. The pretreatment may include: performing alkali etching for 3-20s at a temperature of 50-70°C by using 50-60 g/L of sodium hydroxide, neutralizing for 10-20s a temperature of 15-25°C by using 200-300 ml/L of nitric acid, and performing chemical polishing for 5-20s at a temperature of 90-95°C by using a chemical polishing solution containing 650-750 ml/L of phosphoric acid and 350-250 ml/L of sulfuric acid.

In the preparation method for an aluminum alloy housing according to the embodiment of the present invention, the method of the anodic oxidation can be an anodic oxidation method commonly known in the field. Preferably, the anodic oxidation may include oxidizing the surface of the aluminum alloy housing substrate for 15-50 min under an anode voltage of 13-17 V and at a temperature of 10-21°C by using 190-200 g/L of sulfuric acid.

In the preparation method for an aluminum alloy housing according to the embodiment of the present invention, preferably, in step d, the deprotection can be implemented by using a neutral paint remover to remove the protective film formed on the surface of the aluminum alloy housing substrate. The paint remover in use can be various neutral paint removers commonly known in the field, for example, SH-665 neutral paint remover purchased from Sihui Surface Processing Technology Co., Ltd.

In the preparation method for an aluminum alloy housing according to the embodiment of the present invention, in order to obtain different colors of aluminum alloy housings, the oxide film formed on the surface of the aluminum alloy housing substrate can be dyed after the first anodic oxidation and/or the second anodic oxidation. The dyeing can be implemented by using various dyeing methods commonly known in the art, and dyes of different colors are used to dye the oxide film formed on the surface of the aluminum alloy housing substrate. A single color can be used to dye the oxide film formed after the first anodic oxidation and/or the second anodic oxidation, or a single color can be used for dyeing in a gradient manner to present a gradient color effect. In addition, when dying is performed on both the oxide film formed after the first anodic oxidation and the oxide film formed after the second anodic oxidation, different colors or gradient colors can be used to present a color varying effect.

In the preparation method for an aluminum alloy housing according to the embodiment of the present invention, after the first anodic oxidation, the second anodic oxidation and/or the mechanical polishing, hole sealing treatment can be performed on the surface of the aluminum alloy housing substrate. Various hole sealing methods commonly known in the field can be used for the hole sealing treatment. For example, hole sealing treatment can be performed for 15-20 min at a temperature of 90-95°C by using a conventional sealant.

The preparation method for an aluminum alloy housing according to the present invention is further described below by using exemplary embodiments. However, the present invention is not limited to the following exemplary embodiments.

### Embodiment 1

This embodiment is used to describe the aluminum alloy housing of the present invention and a preparation method for same.

A pressure-casting aluminum alloy rear housing substrate (purchased from BYD Co., Ltd.) for use in a P8-model mobile phone is used as an aluminum alloy housing substrate of the this embodiment. A layer of Vitayon 5680 series anti-etching UV ink (Shenzhen Vitayon Co., Ltd.) was uniformly sprayed on the aluminum alloy housing substrate. Then, the aluminum alloy housing substrate attached with the anti-etching UV ink was dried for 15 min at a temperature of 80°C in a drying oven, so as to cure the anti-etching UV ink.

A film was disposed in a region where a patter needs to be formed on the aluminum alloy housing substrate. A layer of silicone membrane was covered on the film. Then, the film was tightly pressed on the material by using a jig. Exposure was performed for 25s under UV irradiation at an intensity of 100 mJ/cm².

The aluminum alloy housing substrate after the exposure was eluted at room temperature (25°C) by using a sodium carbonate solution with a concentration of 1% by weight, an injection pressure being 200 kPa. An unexposed part of the anti-etching photo-sensitive ink on the aluminum alloy housing substrate was washed away, to show a desired pattern.

The aluminum alloy housing substrate on which the pattern was shown was soaked in an etchant solution consisting of 120 g of ferric chloride, 120 g of phosphoric acid and 100 g of water, and was etched for 5 min at a temperature of 45°C. The etchant solution was stirred continuously.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 15°C, the aluminum alloy housing substrate was subject to neutralization for 10s in nitric acid with a concentration of 250 ml/L, and was cleaned twice with deionized water. Next, at a temperature of 90°C, the aluminum alloy housing substrate was subject to polishing for 10s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on a surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

A neutral paint remover (Sihui Surface Processing Technology Co., Ltd. SH-665) was heated to 80°C. The aluminum alloy housing substrate was soaked in the neutral paint remover for 20 min, taken out, and cleaned twice with deionized water. Then, the aluminum alloy housing substrate was dried in a dryer for 20 min at a temperature of 80°C, to obtain the cleaned and dried aluminum alloy housing substrate.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 15°C, the aluminum alloy housing substrate was subject to neutralization for 10s in nitric acid with a concentration of 250 ml/L, and was cleaned twice with deionized water. Next, at a temperature of 90°C, the aluminum alloy housing substrate was subject to polishing for 10s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on the surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

The anodic oxidation film layer on the surface of the aluminum alloy housing substrate was polished by using a mechanical polishing machine, to reduce the overall thickness of the anodic oxidation film by approximately 2 µm, so that the surface of the anodic oxidation film is glossy and can reflect light.

The aluminum alloy housing substrate after the mechanical polishing was soaked in a sealant YS-509 (purchased from Dongguan Yingshunbao Metals & Dye Co., Ltd.) for 15 min at a temperature of 95°C to seal holes, thereby obtaining the aluminum alloy housing of the present invention.

### Embodiment 2

This embodiment is used to describe the aluminum alloy housing of the present invention and a preparation method for same.

A pressure-casting aluminum alloy rear housing substrate (purchased from BYD Co., Ltd.) for use in a P8-model mobile phone is used as an aluminum alloy housing substrate of the this embodiment. A layer of Vitayon 5680 series anti-etching UV ink (Shenzhen Vitayon Co., Ltd.) was uniformly sprayed on the aluminum alloy housing substrate. Then, the aluminum alloy housing substrate attached with the anti-etching UV ink was dried for 20 min at a temperature of 83°C in a drying oven, so as to cure the anti-etching UV ink.

A film was disposed in a region where a patter needs to be formed on the aluminum alloy housing substrate. A layer of silicone membrane was covered on the film. Then, the film was tightly pressed on the material by using a jig. Exposure was performed for 25s under UV irradiation at an intensity of 100 mJ/cm².

The aluminum alloy housing substrate after the exposure was eluted at room temperature (25°C) by using a sodium carbonate solution with a concentration of 1% by weight, an injection pressure being 200 kPa. An unexposed part of the anti-etching photo-sensitive ink on the aluminum alloy housing substrate was washed away, to show a desired pattern.

The aluminum alloy housing substrate on which the pattern was shown was soaked in an etchant solution consisting of 150 g of ferric chloride, 80 g of phosphoric acid and 100 g of water, and was etched for 1 min at a temperature of 45°C. The etchant solution was stirred continuously.

At a temperature of 70°C, the etched aluminum alloy housing substrate was subject to alkali etching for 20s in a sodium hydroxide aqueous solution with a concentration of 60 g/L, and was cleaned twice with deionized water. Then, at a temperature of 20°C, the aluminum alloy housing substrate was subject to neutralization for 20s in nitric acid with a concentration of 300 ml/L, and was cleaned twice with deionized water. Next, at a temperature of 93°C, the aluminum alloy housing substrate was subject to polishing for 10s in a chemical polishing solution containing 700 ml/L of phosphoric acid and 300 ml/L of sulfuric acid, and was cleaned twice with deionized water. Then, at a temperature of 25°C, the aluminum alloy housing substrate was subject to neutralization for 20s in nitric acid with a concentration of 300 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on a surface of the aluminum alloy housing substrate by means of anodic oxidation. Conditions of the anodic oxidation include: using sulfuric acid with a concentration of 195 g/L as a bath solution, an anode voltage being 17 V, a temperature being 10°C, and an oxidation time being 35 min.

A neutral paint remover (Sihui Surface Processing Technology Co., Ltd. SH-665) was heated to 80°C. The aluminum alloy housing substrate was soaked in the neutral paint remover for 20 min, taken out, and cleaned twice with deionized water. Then, the aluminum alloy housing substrate was dried in a dryer for 20 min at a temperature of 80°C, to obtain the cleaned and dried aluminum alloy housing substrate.

At a temperature of 70°C, the etched aluminum alloy housing substrate was subject to alkali etching for 20s in a sodium hydroxide aqueous solution with a concentration of 60 g/L, and was cleaned twice with deionized water. Then, at a temperature of 20°C, the aluminum alloy housing substrate was subject to neutralization for 20s in nitric acid with a concentration of 300 ml/L, and was cleaned twice with deionized water. Next, at a temperature of 93°C, the aluminum alloy housing substrate was subject to polishing for 10s in a chemical polishing solution containing 700 ml/L of phosphoric acid and 300 ml/L of sulfuric acid, and was cleaned twice with deionized water. Then, at a temperature of 25°C, the aluminum alloy housing substrate was subject to neutralization for 20s in nitric acid with a concentration of 300 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on the surface of the aluminum alloy housing substrate by means of anodic oxidation. Conditions of the anodic oxidation include: using sulfuric acid with a concentration of 195 g/L as a bath solution, an anode voltage being 17 V, a temperature being 10°C, and an oxidation time being 35 min.

The anodic oxidation film layer on the surface of the aluminum alloy housing substrate was polished by using a mechanical polishing machine, to reduce the overall thickness of the anodic oxidation film by approximately 2 µm, so that the surface of the anodic oxidation film is glossy and can reflect light.

The aluminum alloy housing substrate after the mechanical polishing was soaked in a sealant YS-509 (purchased from Dongguan Yingshunbao Metals & Dye Co., Ltd.) for 15 min at a temperature of 95°C to seal holes, thereby obtaining the aluminum alloy housing of the present invention.

### Embodiment 3

This embodiment is used to describe the aluminum alloy housing of the present invention and a preparation method for same.

A pressure-casting aluminum alloy rear housing substrate (purchased from BYD Co., Ltd.) for use in a P8-model mobile phone is used as an aluminum alloy housing substrate of the this embodiment. A layer of Vitayon 5680 series anti-etching UV ink (Shenzhen Vitayon Co., Ltd.) was uniformly sprayed on the aluminum alloy housing substrate. Then, the aluminum alloy housing substrate attached with the anti-etching UV ink was dried for 15 min at a temperature of 80°C in a drying oven, so as to cure the anti-etching UV ink.

A film was disposed in a region where a patter needs to be formed on the aluminum alloy housing substrate. A layer of silicone membrane was covered on the film. Then, the film was tightly pressed on the material by using a jig. Exposure was performed for 25s under UV irradiation at an intensity of 100 mJ/cm².

The aluminum alloy housing substrate after the exposure was eluted at room temperature (25°C) by using a sodium carbonate solution with a concentration of 1% by weight, an injection pressure being 200 kPa. An unexposed part of the anti-etching photo-sensitive ink on the aluminum alloy housing substrate was washed away, to show a desired pattern.

The aluminum alloy housing substrate on which the pattern was shown was soaked in an etchant solution consisting of 120 g of ferric chloride, 120 g of phosphoric acid and 100 g of water, and was etched for 5 min at a temperature of 43°C. The etchant solution was stirred continuously.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, at a temperature of 95°C, the aluminum alloy housing substrate was subject to polishing for 20s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on a surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

A neutral paint remover (Sihui Surface Processing Technology Co., Ltd. SH-665) was heated to 80°C. The aluminum alloy housing substrate was soaked in the neutral paint remover for 20 min, taken out, and cleaned twice with deionized water. Then, the aluminum alloy housing substrate was dried in a dryer for 20 min at a temperature of 80°C, to obtain the cleaned and dried aluminum alloy housing substrate.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, at a temperature of 95°C, the aluminum alloy housing substrate was subject to polishing for 20s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on the surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

The anodic oxidation film layer on the surface of the aluminum alloy housing substrate was polished by using a mechanical polishing machine, to reduce the overall thickness of the anodic oxidation film by approximately 2 µm, so that the surface of the anodic oxidation film is glossy and can reflect light.

The aluminum alloy housing substrate after the mechanical polishing was soaked in a sealant YS-509 (purchased from Dongguan Yingshunbao Metals & Dye Co., Ltd.) for 15 min at a temperature of 95°C to seal holes, thereby obtaining the aluminum alloy housing of the present invention.

### Embodiment 4

This embodiment is used to describe the aluminum alloy housing of the present invention and a preparation method for same.

A pressure-casting aluminum alloy rear housing substrate (purchased from BYD Co., Ltd.) for use in a P8-model mobile phone is used as an aluminum alloy housing substrate of the this embodiment. A layer of Vitayon 5680 series anti-etching UV ink (Shenzhen Vitayon Co., Ltd.) was uniformly sprayed on the aluminum alloy housing substrate. Then, the aluminum alloy housing substrate attached with the anti-etching UV ink was dried for 15 min at a temperature of 80°C in a drying oven, so as to cure the anti-etching UV ink.

A film was disposed in a region where a patter needs to be formed on the aluminum alloy housing substrate. A layer of silicone membrane was covered on the film. Then, the film was tightly pressed on the material by using a jig. Exposure was performed for 25s under UV irradiation at an intensity of 100 mJ/cm².

The aluminum alloy housing substrate after the exposure was eluted at room temperature (25°C) by using a sodium carbonate solution with a concentration of 1% by weight, an injection pressure being 200 kPa. An unexposed part of the anti-etching photo-sensitive ink on the aluminum alloy housing substrate was washed away, to show a desired pattern.

The aluminum alloy housing substrate on which the pattern was shown was soaked in an etchant solution consisting of 120 g of ferric chloride, 120 g of phosphoric acid and 100 g of water, and was etched for 10 min at a temperature of 40°C. The etchant solution was stirred continuously.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, at a temperature of 95°C, the aluminum alloy housing substrate was subject to polishing for 10s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on a surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

A neutral paint remover (Sihui Surface Processing Technology Co., Ltd. SH-665) was heated to 80°C. The aluminum alloy housing substrate was soaked in the neutral paint remover for 20 min, taken out, and cleaned twice with deionized water. Then, the aluminum alloy housing substrate was dried in a dryer for 20 min at a temperature of 80°C, to obtain the cleaned and dried aluminum alloy housing substrate.

At a temperature of 50°C, the etched aluminum alloy housing substrate was subject to alkali etching for 10s in a sodium hydroxide aqueous solution with a concentration of 55 g/L, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, at a temperature of 95°C, the aluminum alloy housing substrate was subject to polishing for 10s in a chemical polishing solution containing 650 ml/L of phosphoric acid and 350 ml/L of sulfuric acid, and was cleaned twice with deionized water. Then, at a temperature of 25°C, the aluminum alloy housing substrate was subject to neutralization for 10s in nitric acid with a concentration of 250 ml/L, and was cleaned twice with deionized water. Next, the aluminum alloy housing substrate was dried for 20 min at a temperature of 80°C in a drying oven, to obtain the cleaned and dried aluminum alloy housing substrate.

An anode film was formed on the surface of the aluminum alloy housing substrate by means of anodic oxidation. Conditions of the anodic oxidation include: using sulfuric acid with a concentration of 190 g/L as a bath solution, an anode voltage being 15 V, a temperature being 19°C, and an oxidation time being 35 min.

The anodic oxidation film layer on the surface of the aluminum alloy housing substrate was polished by using a mechanical polishing machine, to reduce the overall thickness of the anodic oxidation film by approximately 2 µm, so that the surface of the anodic oxidation film is glossy and can reflect light.

The aluminum alloy housing substrate after the mechanical polishing was soaked in a sealant YS-509 (purchased from Dongguan Yingshunbao Metals & Dye Co., Ltd.) for 15 min at a temperature of 95°C to seal holes, thereby obtaining the aluminum alloy housing of the present invention.

### Performance tests

Performance tests are performed, according to the following methods, on the aluminum alloy housings with clear convex-concave patterns obtained in Embodiments 1-4. Test results are as shown in Table 1.

### Glossiness test

A gloss meter (German BKY micro gloss meter A-4460) was used to test the glossiness of the surfaces of the aluminum alloy housings obtained in Embodiments 1-4. The results are as shown in Table 1.

### Scratch resistance test

A UNI pen having 2H hardness was used to scratch at three different places of a sample with a force of 800 g applied at an angle of 45 degrees and a stroke of 10 mm. It is observed whether an evident scratch appears on the sample. If no, it indicates that the sample is qualified.

### High temperature resistance test

The sample was put into a precise high temperature test chamber (HOLINK HRHL45), was heated for 240 hours at a temperature of 85°C, and stayed for 2 hours at room temperature. It is observed whether fall-off, deformation, crack, and color change occurs in the appearance of the sample. If no, it indicates that the sample is qualified.

### Low temperature resistance test

The sample was put into a constant temperature and humidity test chamber (Taiwan KSON, THS-2001), stayed for 240 hours at a temperature of -40°C, and then stayed for 2 hours at room temperature. It is observed whether fall-off, deformation, crack, and color change occurs in the appearance of the sample. If no, it indicates that the sample is qualified.

### Moisture resistance test

The sample was put into a constant temperature and humidity test chamber (Taiwan KSON, HTS-400) with a humidity of 90% and a temperature of 60°C, stayed for 96 hours, and then stayed for 2 hours at room temperature. It is observed whether fall-off, deformation, crack, and color change occurs in the appearance of the sample. If no, it indicates that the sample is qualified.

### Temperature shock test

The sample was put into a thermal shock test chamber (HOLINK HTS-400), and first stayed for 1 hour in an environment with a temperature of -40°C; then, the temperature was switched to 85°C (a switching time was 15s), and the sample stayed for 1 hour at the temperature of 85°C. This process is repeated 12 times (24 hours). It is observed whether fall-off, deformation, crack, and color change occurs in the appearance of the sample. If no, it indicates that the sample is qualified.

### Salt spray test

The sample was put into a test chamber (HOLINK H-SST-90 salt spray tester) with a temperature of 30°C and a humidity of 85% or higher. A solution with pH=6.8 (content of the solution: 50 g/L of NaCl) was used to spray continuously for 48 hours. Then, the sample was taken out, washed with normal-temperature water for 5 min, and dried with a drier. The sample stayed for 1 hour at room temperature. It is observed whether fall-off, deformation, crack, and color change occurs in the appearance of the sample. If no, it indicates that the sample is qualified.

**Table 1 Performance Test Results of Aluminum Alloy Housings Obtained in Embodiments 1-4**

| | glossiness | Scratch resistance test | High temperature test | Low temperature test | Moisture test | Temperature shock test | Salt spray test |
|---|---|---|---|---|---|---|---|
| Embodiment 1 | 90.3 | Qualified | Qualified | Qualified | Qualified | Qualified | Qualified |
| Embodiment 2 | 119.2 | Qualified | Qualified | Qualified | Qualified | Qualified | Qualified |
| Embodiment 3 | 120.4 | Qualified | Qualified | Qualified | Qualified | Qualified | Qualified |
| Embodiment 4 | 150.1 | Qualified | Qualified | Qualified | Qualified | Qualified | Qualified |

It can be seen from the foregoing table that, the surface of the aluminum alloy housing of the present invention is not abraded easily, and the surface layer does not fall off easily, thereby improving the durability of the aluminum alloy housing. Moreover, with the convex-concave pattern, the aluminum alloy housing achieves a beautiful appearance effect, and has a clear bumpy solid texture. Therefore, the aluminum alloy housing provided by the present invention is beautiful and durable. In addition, after mechanical polishing, the surfaces of the aluminum alloy housings obtained in Embodiments 1-4 are also glossy.

In the description of the specification, the description made with reference to terms such as "one embodiment", "some embodiments", "example", "specific example", or "some examples" means that a specific characteristic, structure, material or feature described with reference to the embodiment or example is included in at least one embodiment or example of the present invention. In the specification, the illustrative expression of the foregoing terms is not necessarily intended for the same embodiment or example. Moreover, the described specific characteristic, structure, material or feature can be combined properly in any one or more embodiments or examples. In addition, without causing conflicts, a person skilled in the art can integrate and combine different embodiments or examples described in the specification or characteristics of different embodiments or examples.

Although the embodiments of the present invention have been shown and described above, it can be understood that the foregoing embodiments are merely examples and should not be construed as limitations on the present invention. A person of ordinary skill can make changes, modifications, replacements and transformations on the embodiments without departing from the scope of the present invention.

## Claims

1. An aluminum alloy housing, wherein an external surface of the aluminum alloy housing has a convex portion and a concave portion, the convex portion has a convex oxide film, the concave portion has a concave oxide film, and surfaces of the convex oxide film and the concave oxide film have a glossiness of 90-150.

2. The aluminum alloy housing according to claim 1, wherein a height difference between the convex portion and the concave portion is 0.05-0.2 mm.

3. The aluminum alloy housing according to claim 1 or 2, wherein the convex oxide film and the concave oxide film have different colors.

4. A preparation method for an aluminum alloy housing, comprising steps of:
step a: performing anti-etching protection on a surface of an aluminum alloy housing substrate, so as to form a protective film on the surface of the aluminum alloy housing substrate;
step b: forming, by using an etching method, a pattern layer having a convex-concave pattern on the surface of the aluminum alloy housing substrate on which the protective film is formed;
step c: performing first anodic oxidation on the surface of the aluminum alloy housing substrate having the pattern layer;
step d: removing the protective film from the surface of the aluminum alloy housing substrate on which the first anodic oxidation has been performed, to perform deprotection;
step e: performing second anodic oxidation on the surface of the aluminum alloy housing substrate from which the protective film has been removed; and
step f: performing mechanical polishing on the surface of the aluminum alloy housing substrate on which the second anodic oxidation has been performed.

5. The preparation method according to claim 4, wherein in step a, the anti-etching protection comprises: spraying an anti-etching photo-sensitive ink on the surface of the aluminum alloy housing substrate and curing; disposing a film in a region where a pattern needs to be formed, covering the film with a silicone membrane, and performing exposure; and washing away an unexposed part of the anti-etching photo-sensitive ink to perform development.

6. The preparation method according to claim 4 or 5, wherein a condition of the curing is: drying for 10-20 min at a temperature of 80-85°C.

7. The preparation method according to any of claims 4 to 6, wherein in step b, the etching method is etching for 1-10 min at a temperature of 40-45°C by using an acid etchant solution.

8. The preparation method according to any of claims 4 to 7, wherein the acid etchant solution contains 100-150 parts by weight of ferric chloride and 80-120 parts by weight of phosphoric acid with respect to 100 parts by weight of water.

9. The preparation method according to any of claims 4 to 8, wherein the first anodic oxidation and/or the second anodic oxidation comprises performing pretreatment on the surface of the aluminum alloy housing substrate and then forming an anode film by means of anodic oxidation.

10. The preparation method according to any of claims 4 to 9, wherein the pretreatment comprises: performing alkali etching for 3-20s at a temperature of 50-70°C by using 50-60 g/L of sodium hydroxide, neutralizing for 10-20s a temperature of 15-25°C by using 200-300 ml/L of nitric acid, and performing chemical polishing for 5-20s at a temperature of 90-95°C by using a chemical polishing solution containing 650-750 ml/L of phosphoric acid and 350-250 ml/L of sulfuric acid.

11. The preparation method according to any of claims 4 to 10, wherein the anodic oxidation comprises oxidizing the surface of the aluminum alloy housing substrate for 15-50 min under an anode voltage of 13-17 V and at a temperature of 10-21°C by using 190-200 g/L of sulfuric acid.
